# EUROPÄISCHE PATENTSCHRIFT

(11) **EP 1 148 983 B1**
(45) Veröffentlichungstag und Bekanntmachung des Hinweises auf die Patenterteilung: **13.04.2005**
(21) Anmeldenummer: 00904808.3
(22) Anmeldetag: 03.01.2000
(51) Int. Cl.: B28D 5/04, H01L 21/304, H01L 21/00, H01L 33/00

(54) **VERFAHREN UND VORRICHTUNG ZUR FORMGEBUNG VON HALBLEITEROBERFLÄCHEN**
METHOD AND DEVICE FOR SHAPING SURFACES OF SEMICONDUCTORS
PROCEDE ET DISPOSITIF POUR FACONNER DES SURFACES DE SEMICONDUCTEURS

(30) Priorität: 04.01.1999 DE 19900051
(43) Veröffentlichungstag der Anmeldung: 31.10.2001
(73) Patentinhaber: Infineon Technologies AG, 81669 München (DE)
(72) Erfinder: WIPIEJEWSKI, Torsten, D-93049 Regensburg (DE)
(74) Vertreter: Graf Lambsdorff, Matthias, Dr.
(86) Internationale Anmeldenummer: PCT/DE2000/000009
(87) Internationale Veröffentlichungsnummer: WO 2000/041221

(56) Entgegenhaltungen:
- EP-A- 0 757 262
- DE-B- 1 777 318
- US-A- 4 240 311
- US-A- 4 829 013
- US-A- 5 306 646
- US-A- 5 378 289
- PATENT ABSTRACTS OF JAPAN vol. 1996, no. 01, 31. Januar 1996 (1996-01-31) & JP 07 232319 A (M SETETSUKU KK), 5. September 1995 (1995-09-05)
- PATENT ABSTRACTS OF JAPAN vol. 005, no. 176 (E-081), 12. November 1981 (1981-11-12) & JP 56 103484 A (FUJI PHOTO FILM CO LTD), 18. August 1981 (1981-08-18)

## Beschreibung

Die Erfindung bezieht sich auf ein Verfahren zur Formgebung von Halbleiteroberflächen und eine Vorrichtung zur Durchführung des Verfahrens.

Seit vielen Jahren finden optische Mikrokomponenten, wie z.B. Mikrolinsen und Mikrolinsen-Arrays in der Optoelektronik Verwendung. Besonders einfach lassen sich konvexe Mikrolinsen durch wiedererweichte Photolackstrukturen (photo resist reflow) erzeugen. Die konvexen Formen bilden sich von selbst beim Erwärmen durch die Oberflächenspannung im Photolack und können durch Trockenätzverfahren z.B. in Si-Halbleiterscheiben übertragen werden. Wesentlich schwieriger gestaltet sich die reproduzierbare Herstellung von konkaven Strukturen, weil kein selbstjustierender Photolackprozeß wie der Reflow zur Verfügung steht. In zahlreichen Anwendungen könnten konkave Mikrolinsen jedoch vorteilhaft eingesetzt werden, wie z.B. zur Korrektur des Astigmatismus der Ausgangsstrahlung von kantenemittierenden Laserdioden. Meist wird versucht, konkave Strukturen durch naßchemische Ätzverfahren unter Ausnutzung von Diffusionseffekten zu erzeugen. Solche Verfahren haben wegen der schlechten Reproduzierbarkeit und mangelhaften Oberflächenqualität bislang keinen Eingang in großtechnischen Anwendungen gefunden.

In der US-A-5,378,289 wird ein Verfahren zur Formgebung einer Halbleiteroberfläche beschrieben, bei welchem eine Oberfläche aus amorphem Silizium gleichzeitig verformt und kristallisiert wird, indem eine mit Pyramiden versehene texturierte Druckform aus kristallinem Silizium unter Temperatureinwirkung in die amorphe Siliziumoberfläche eingepreßt wird. Dadurch kann ein kristalliner Siliziumfilm hergestellt werden, welcher eine texturierte Oberfläche entsprechend der texturierten Oberfläche der für den Preßvorgang verwendeten Form aufweist.

Demgemäß liegt der vorliegenden Erfindung die Aufgabe zugrunde, ein gleichzeitig einfaches und kostengünstiges Verfahren anzugeben, mit welchem eine Formgebung von Halbleiteroberflächen erreicht werden kann. Insbesondere ist es Aufgabe der vorliegenden Erfindung, mit einem derartigen Verfahren konkave Oberflächenstrukturen zu erzeugen.

Diesen Aufgaben werden durch die kennzeichnenden Merkmale jeweils der nebengeordneten Patentansprüche 1 oder 2 gelöst. Ausserdem ist eine Vorrichtung fur Durchführung des Verfahrens nach Anspruch 1 angegeben.

Vorzugsweise weist dabei eine erste Platte eine zu der gewünschten Form der Halbleiteroberfläche negative Form auf und eine zweite Platte weist eine ebene Fläche auf.

Zur Erzielung der Preßwirkung kann auf mindestens eine der beiden Platten oder auf beide Platten ein Druck in senkrechter Richtung auf die Halbleiterscheibe ausgeübt werden, wobei der Druck nach den Eigenschaften des zu formenden Halbleitermaterials vorzugsweise größer als 1 MPa und die Temperatur vorzugsweise größer als 600°C ist.

Der Preßvorgang kann in einer Inertgas- oder Schutzgasatmosphäre durchgeführt werden. Das zu formende Halbleitermaterial ist ein Verbindungshalbleiter. Zur Verhinderung der Dekomposition des Verbindungshalbleiters wird eine mit einem Element des verbindungshalbleiters angereicherte Atmosphäre bei der Formgebung verwendet. Beispielsweise kann bei Verwendung von GaAs als zu formendem Halbleiter das verfahren in einer mit Arsen angereicherten Atmosphäre durchgeführt werden.

Auf die erfindungsgemäße Art lassen sich vielfältige Formen wie konvexe oder konkave Strukturen in runder oder scharfkantiger Ausführung herstellen. Es kann die gesamte Halbleiterscheibe dabei gleichzeitig strukturiert werden, wodurch eine kostengünstige Massenfertigung gewährleistet ist.

Im folgenden werden Ausführungsbeispiele der vorliegenden Erfindung anhand der Figuren näher dargestellt. Es zeigen:
Fig.1 ein Ausführungsbeispiel für eine Vorrichtung zur Durchführung des erfindungsgemäßen Verfahrens;
Fig.2 eine vergrößerte Darstellung des Vorgangs der Preßformung;
Fig.3 mit dem erfindungsgemäßen Verfahren hergestellte konkave Linsen;
Fig.4 eine mit dem erfindungsgemäßen Verfahren hergestellte Vertikalresonator-Leuchtdiode.

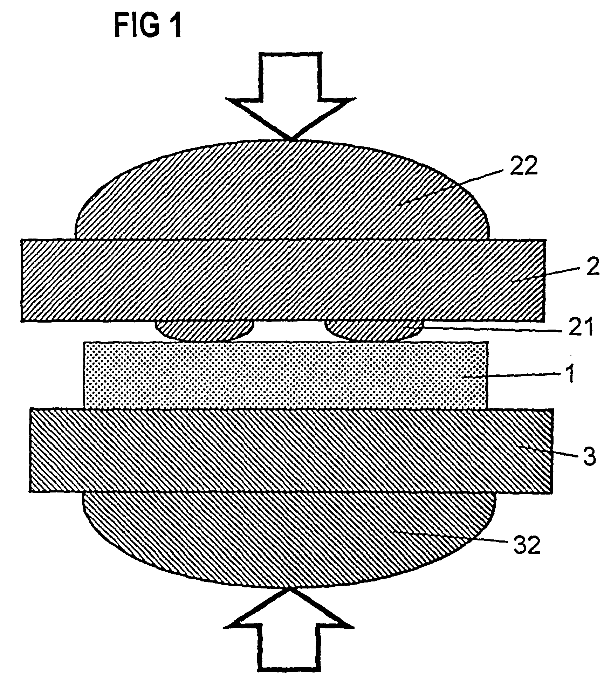

In Fig.1 ist ein Ausführungsbeispiel für eine Vorrichtung zur Durchführung des erfindungsgemäßen Verfahrens dargestellt. Bei dieser wird die zu formende Halbleiterscheibe 1 zwischen zwei Platten 2, 3 eingespannt, von denen die erste Platte 2 die formgebende Platte ist und die zweite Platte 3 der Halterung oder Unterstützung der Halbleiterscheibe 1 dient. Die erste Formplatte 2 besitzt eine Oberflächenstruktur, die das Negativ zu der gewünschten Form der Halbleiterscheibe 1 darstellt. Wie beispielhaft dargestellt ist, kann diese Oberflächenstruktur konvexe Wölbungen 21 aufweisen, mit denen durch den Formgebungsprozeß in der Halbleiteroberfläche konkave Vertiefungen erzeugt werden sollen. Wie ferner dargestellt ist, kann durch eine nicht dargestellte Preßvorrichtung auf beide Platten 2, 3 eine einander entgegengesetzte Druckkraft in senkrechter Richtung auf die Halbleiterscheibe 1 ausgeübt werden, so daß bei dem Preßvorgang bei erhöhter Temperatur die formgebende Platte 2 mit der Oberflächenstruktur in die Halbleiteroberfläche eingedrückt wird. Der hierfür aufzuwendende Gesamtdruck hängt von den für das Halbleitermaterial der Halbleiterscheibe 1 und die Platten 2, 3 verwendeten Materialien sowie von der Umgebungstemperatur ab. Aus der Publikation "GaAs to InP Wafer Fusing" in J. Appl. Phys., in Bd.78, Seiten 4227-4237 von 1995 von R.J.Ram et al. ist bekannt, daß bei dem chemischen Verbinden zweier unterschiedlicher Halbleitermaterialien, nämlich GaAs und InP Drücke oberhalb von 1 MPa und Temperaturen oberhalb von 600°C erforderlich sind. Es ist daher zu erwarten, daß auch bei dem erfindungsgemäßen Verfahren die Bedingungen in dieser Weise gewählt werden müssen. Zur Erleichterung der Prozeßbedingungen sollte das zu formende Halbleitermaterial bei einer gegebenen Formgebungstemperatur eine geringere Härte als das Plattenmaterial aufweisen.

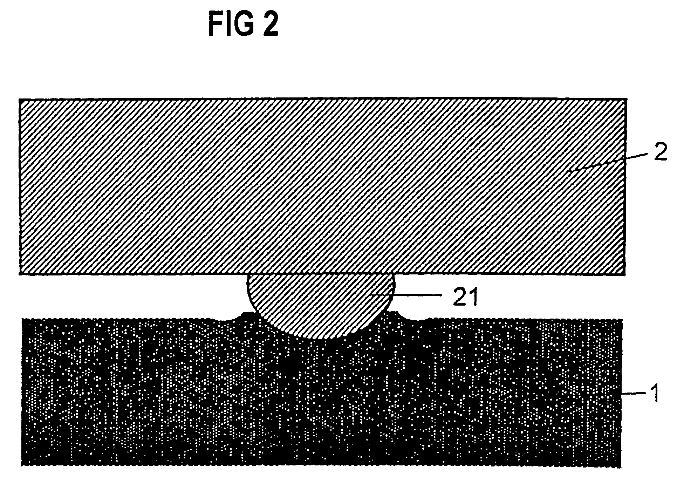

In Fig.2 ist der Formgebungsprozeß nochmals vergrößert dargestellt. Die Atome des zu pressenden Halbleiters weichen unter dem hohen Druck seitlich aus und formen so ein negatives Abbild des Oberflächenprofils der formgebenden Platte 2.

Es ist vorteilhaft, wenn die bei beiden Platten 2, 3 aufzuwendende Druckkraft möglichst gleichmäßig auf die Platten 2, 3 verteilt wird. Wenn daher die Druckkraft, wie durch die Pfeile angedeutet ist, im wesentlichen entlang einer auf der Halbleiterscheibe 1 senkrechten Linie erzeugt wird, sind vorzugsweise auf beiden Platten 2, 3 domartige Strukturen 22, 32 zur lateralen Verteilung der Druckkraftwirkung auf die Platten aufgebracht.

Es kann zur Vereinfachung des Aufbaus der Preßvorrichtung auch vorgesehen sein, daß nur auf eine der beiden Platten 2, 3 eine Druckkraft ausgeübt wird.

Ferner kann vorgesehen sein, daß der Formungsprozeß unter einer Inertgas- oder Schutzgasatmosphäre, beispielsweise unter Stickstoff oder Argon durchgeführt wird. Wenn ein Verbindungshalbleiter geformt werden soll, so kann es bei dem Formungsprozeß in unerwünschter Weise zu einer Dekomposition des Verbindungshalbleiters kommen. Daher ist es in solchen Fällen vorgesehen, daß eine mit einem Element des Verbindungshalbleiters angereicherte Atmosphäre während des Formungsprozesses erzeugt wird. Bei der Formung eines III-V-Halbleiters wie GaAs kann beispielsweise eine mit dem Gruppe-V-Element (Arsen) angereicherte Atmosphäre verwendet werden. Dadurch kann die Dekomposition wirksam verhindert werden.

Die erste formgebende Platte 2 kann je nach Anwendung aus Silizium oder einem Metall, wie Molybdän, oder anderen geeigneten Stoffen bestehen. Die formgebende Platte wird vor dem Formgebungsprozeß so bearbeitet, daß das entsprechend negative Oberflächenprofil zu dem gewünschten Oberflächenprofil der Halbleiterscheibe entsteht. Dafür können je nach Plattenmaterial Ätzprozesse oder andere schleifende oder polierende Verfahren eingesetzt werden. Beispielsweise können durch Trockenätztechnik strukturierte Siliziumscheiben, die konvexe Mikrolinsen enthalten, eingesetzt werden, um in der zu pressenden Halbleiterscheibe konkave Linsenstrukturen zu erzeugen.

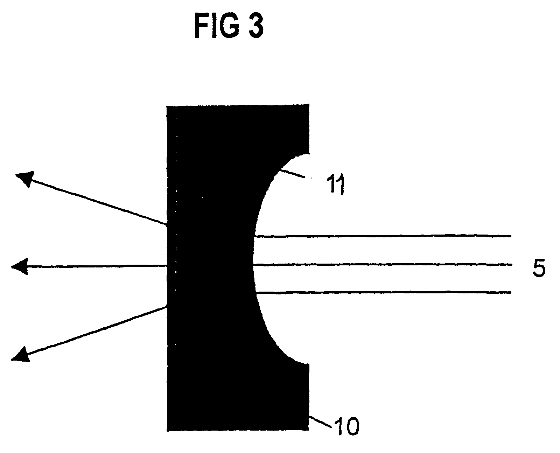

Ein Beispiel für eine derartige konkave Linsenstruktur ist in Fig.3 dargestellt, welche eine aus dem Verbindungshalbleiter GaP gefertigte konkave Mikrolinse 10 zeigt, die durch das erfindungsgemäße Verfahren erzeugt wurde. Die Mikrolinse 10 weist im wesentlichen eine durch das erfindungsgemäße Verfahren geformte gewölbte, konkave Vertiefung 11 auf. Der Verbindungshalbleiter GaP hat den Vorteil, daß er bei entsprechender Dicke eine für sichtbares Licht geringe Absorption aufweist und somit nahezu transparent ist und außerdem eine im Vergleich zu Glas sehr hohe Brechzahl aufweist. Daher werden durch die konkave Mikrolinse 10 die Lichtstrahlen 5, wie dargestellt in Fig.3, beim Durchtritt sehr stark gebrochen.

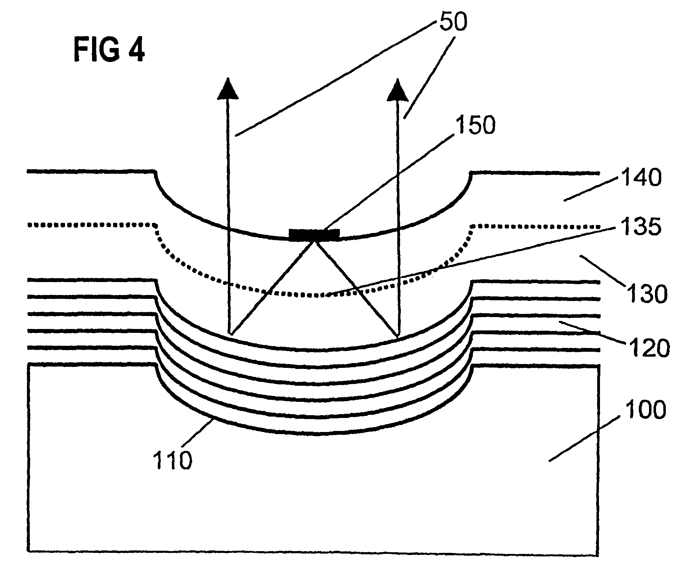

Das erfindungsgemäße Verfahren kann in einer weiteren Anwendung dazu dienen, Lichtemissionsdioden oder Laserdioden herzustellen. Dabei werden zunächst konkave Strukturen auf einer Halbleiterscheibe erzeugt und auf dieser Basis weitere Prozeßschritte zur Herstellung der Lichtemissionsdiode oder Laserdiode durchgeführt. In Fig.4 ist eine auf diese Weise hergestellte Lichtemissionsdiode dargestellt, die als Ausgangsmaterial ein n-leitendes GaAs-Substrat 100 verwendet, in das durch das erfindungsgemäße Verfahren eine gewölbte Vertiefung 110 geformt wurde. In einem weiteren Prozeßschritt wird nun auf mindestens einen, die Vertiefung 110 enthaltenden Abschnitt eine Bragg-Reflektor-Schichtenfolge 120 epitaktisch aufgewachsen. Auf diese Struktur wird dann eine aus einer n-dotierten Schicht 130 und einer p-dotierten Schicht 140 bestehende aktive Schichtenfolge epitaktisch aufgewachsen, die einen lichterzeugenden pn-Übergang 135 an der Grenzfläche der Schichten 130 und 140 enthält. Die Stromzufuhr erfolgt durch einen an der p-Seite angebrachten p-Kontakt 150 und einen am n-Substrat 100 angebrachten n-Kontakt (nicht dargestellt).

Durch den gewölbten Bragg-Reflektor wird die von dem lichterzeugenden pn-Übergang nach unten abgestrahlte Ausgangsstrahlung weitgehend senkrecht zur Oberfläche reflektiert, wodurch sich eine hohe Auskoppeleffizienz ergibt. Es kann jedoch auch auf die Bragg-Reflektor-Schichtenfolge verzichtet werden, so daß auf die als Mikrolinse wirkende Vertiefung 110 lediglich die aktive Schichtenfolge mit dem pn-Übergang 135 aufgewachsen wird.

Weiterhin kann jedoch die in Fig.4 gezeigte Struktur auch zu einer Vertikalresonator-Laserdiode weitergebildet werden. Dazu muß lediglich oberhalb der aktiven Schichtenfolge eine zweite Bragg-Reflektor-Schichtenfolge zur Bildung eines Resonators epitaktisch abgeschieden werden. Anschließend kann die Strukturierung der Vertikalresonator-Laserdiode mit den bekannten Verfahren der Technik durchgeführt werden.

## Patentansprüche

1. Verfahren zur Formgebung von Halbleiteroberflächen, bei welchem
- eine Halbleiterscheibe (1; 100) mit einer zu formenden Oberfläche zwischen zwei Platten (2, 3) eingespannt wird, wobei
- mindestens eine Platte (2) eine zu der gewünschten Form einer Halbleiteroberfläche negative Form aufweist und
- die Halbleiteroberfläche bei erhöhter Temperatur von den Platten (2, 3) gepreßt wird,
**dadurch gekennzeichnet, daß**
- die Halbleiterscheibe (1; 100) einen Verbindungshalbleiter aufweist und das Verfahren in einer mit einem Element des Verbindungshalbleiters angereicherten Atmosphäre durchgeführt wird.

2. Verfahren nach dem Oberbegriff des Patentanspruchs 1 zur Herstellung einer Lichtemissionsdiode,
**dadurch gekennzeichnet, daß**
- in der Oberfläche eine Struktur mit mindestens einer gewölbten Vertiefung (11; 110), insbesondere eine Mikrolinse (10), erzeugt wird,
- auf einem die Vertiefung (11; 110) enthaltenden Abschnitt eine aktive Schichtenfolge (120, 130, 140) aufgewachsen wird und
- die erhaltene Struktur mit elektrischen Kontakten (150) versehen wird.

3. Verfahren nach Anspruch 1 oder 2, bei welchem eine erste Platte (2) eine zu der gewünschten Form einer Halbleiteroberfläche der Halbleiterscheibe (1; 100) negative Form aufweist und eine zweite Platte (3) eine ebene Fläche aufweist.

4. Verfahren nach einem der vorhergehenden Ansprüche, bei welchem zur Erzielung der Preßwirkung auf mindestens eine der beiden Platten (2, 3) ein Druck in senkrechter Richtung auf die Halbleiterscheibe (1; 100) ausgeübt wird.

5. Verfahren nach Anspruch 4, bei welchem auf beide Platten ein Druck in senkrechter Richtung auf die Halbleiterscheibe (1; 100) ausgeübt wird.

6. Verfahren nach Anspruch 4 oder 5, bei welchem der Druck größer als 1 MPa und die Temperatur größer als 600°C ist.

7. Verfahren nach einem oder mehreren der vorhergehenden Ansprüche, welches in einer Inertgas- oder Schutzgasatmosphäre, insbesondere unter Stickstoff oder Argon, durchgeführt wird.

8. Verfahren nach Anspruch 1, bei welchem der Verbindungshalbleiter GaAs ist und das Verfahren in einer mit Arsen angereicherten Atmosphäre durchgeführt wird.

9. Verfahren nach einem der Ansprüche 1 oder 3 bis 7, bei welchem die Form der mindestens einen Platte (2) konvexe Strukturen (21) enthält und durch den Preßvorgang in der Halbleiteroberfläche konkave Strukturen (11; 110), insbesondere Mikrolinsen (10), erzeugt werden.

10. Verfahren nach Anspruch 2, bei welchem vor dem Aufwachsen der aktiven Schichtenfolge (120, 130, 140) auf einem die Vertiefung (11; 110) enthaltenden Abschnitt eine Bragg-Reflektor-Schichtenfolge (120) aufgewachsen wird.

11. Verfahren nach Anspruch 10, bei welchem nach dem Aufwachsen der aktiven Schichtenfolge (120, 130, 140) auf einem die Vertiefung (11; 110) enthaltenden Abschnitt eine weitere Bragg-Reflektor-Schichtenfolge aufgewachsen wird, so daß eine Vertikal-Resonator-Laserdiode erzeugt wird.

12. Vorrichtung zur Durchführung des Verfahrens nach Anspruch 1, enthaltend
- zwei Platten (2, 3), von denen mindestens eine eine zu der gewünschten Form einer Halbleiteroberfläche der Halbleiterscheibe (1) negative Form aufweist und
- eine Preßvorrichtung, mit der auf mindestens eine der beiden Platten (2, 3) ein Druck in senkrechter Richtung auf die Halbleiterscheibe (1) ausgeübt werden kann,
**dadurch gekennzeichnet, daß**
- auf der der Halbleiterscheibe (1) abgewandten Seite der Platten (2, 3) domartige Strukturen (22, 32) zur Verteilung der Druckkraft aufgebracht sind.

13. Vorrichtung nach Anspruch 12, bei welcher eine erste Platte (2) eine zu der gewünschten Form der Halbleiteroberfläche der Halbleiterscheibe (1) negative Form aufweist und eine zweite Platte (3) eine ebene Fläche aufweist.

14. Vorrichtung nach einem der Ansprüche 12 oder 13, bei welcher die zu pressende Halbleiterscheibe (1) bei der Formgebungstemperatur eine geringere Härte als das Material der formgebenden Platte (2) aufweist.

15. Vorrichtung nach einem der Ansprüche 12 bis 14, bei welcher die Platten (2, 3) Silizium oder ein Metall, insbesondere Molybdän, enthalten, und insbesondere aus diesen Materialien bestehen.

## Claims

1. Method for shaping semiconductor surfaces, in which
- a semiconductor wafer (1; 100) with a surface to be shaped is clamped in between two plates (2, 3), in which case
- at least one plate (2) has a negative form with respect to the desired form of a semiconductor surface and
- the semiconductor surface is pressed by the plates (2, 3) at elevated temperature,
**characterized in that**
- the semiconductor wafer (1; 100) has a compound semiconductor and the method is carried out in an atmosphere enriched with an element of the compound semiconductor.

2. Method according to the preamble of Patent Claim 1 for fabricating a light-emitting diode,
**characterized in that**
- a structure having at least one curved depression (11; 110), in particular a microlens (10), is produced in the surface,
- an active layer sequence (120, 130, 140) is grown on a section containing the depression (11; 110), and
- the structure obtained is provided with electrical contacts (150).

3. Method according to Claim 1 or 2, in which a first plate (2) has a negative form with respect to the desired form of a semiconductor surface of the semiconductor wafer (1; 100) and a second plate (3) has a planar area.

4. Method according to one of the preceding claims, in which, in order to obtain the pressing action, a pressure is exerted on at least one of the two plates (2, 3) in a direction perpendicular to the semiconductor wafer (1; 100).

5. Method according to Claim 4, in which a pressure is exerted on both plates in a direction perpendicular to the semiconductor wafer (1; 100).

6. Method according to Claim 4 or 5, in which the pressure is greater than 1 MPa and the temperature is greater than 600°C.

7. Method according to one or more of the preceding claims, which is carried out in an inert-gas or protective-gas atmosphere, in particular under nitrogen or argon.

8. Method according to Claim 1, in which the compound semiconductor is GaAs and the method is carried out in an atmosphere enriched with arsenic.

9. Method according to one of Claims 1 or 3 to 7, in which the form of the at least one plate (2) contains convex structures (21) and concave structures (11; 110), in particular microlenses (10), are produced by the pressing process in the semiconductor surface.

10. Method according to Claim 2, in which a Bragg reflector layer sequence (120) is grown before the growth of the active layer sequence (120, 130, 140) on a section containing the depression (11; 110).

11. Method according to Claim 10, in which a further Bragg reflector layer sequence is grown after the growth of the active layer sequence (120, 130, 140) on a section containing the depression (11; 110), with the result that a vertical resonator laser diode is produced.

12. Apparatus for carrying out the method according to Claim 1, containing
- two plates (2, 3), at least one of which has a negative form with respect to the desired form of a semiconductor surface of the semiconductor wafer (1), and
- a pressing apparatus with which a pressure can be exerted on at least one of the two plates (2, 3) in a direction perpendicular to the semiconductor wafer (1),
**characterized in that**
- dome-like structures (22, 32) for distributing the compressive force are applied on that side of the plates (2, 3) which is remote from the semiconductor wafer (1).

13. Apparatus according to Claim 12, in which a first plate (2) has a negative form with respect to the desired form of the semiconductor surface of the semiconductor wafer (1) and a second plate (3) has a planar area.

14. Apparatus according to one of Claims 12 and 13, in which, at the shaping temperature, the semiconductor wafer (1) to be pressed has a lower hardness than the material of the shaping plate (2).

15. Apparatus according to one of Claims 12 to 14, in which the plates (2, 3) contain silicon or a metal, in particular molybdenum, and, in particular, are composed of these materials.

## Revendications

1. Procédé de conformation de surfaces de semi-conducteur dans lequel
- on bloque une tranche (1, 100) de semi-conducteur ayant une surface à conformer entre deux plateaux (2, 3), dans lequel
- au moins l'un des plateaux (2) a une forme négative par rapport à la forme souhaitée d'une surface de semi-conducteur, et
- on comprime la surface de semi-conducteur à haute température par lés plateaux (2, 3),
**caractérisé en ce que**
la tranche (1, 100) de semi-conducteur comporte un semi-conducteur à composé et l'on effectue le procédé dans une atmosphère enrichie en un élément du semi-conducteur à composé.

2. Procédé suivant le préambule de la revendication 1 de fabrication d'une diode électroluminescente,
**caractérisé en ce que**
- on produit dans la surface une structure ayant au moins une cavité (11, 110) courbée, notamment une lentille (10) microscopique ;
- on fait croître une succession (120, 130, 140) de couches actives sur une partie contenant la cavité (11, 110) ; et
- on munit la structure obtenue de contacts (150) électriques.

3. Procédé suivant la revendication 1 ou 2, dans lequel un premier plateau (2) a une forme négative correspondant à la forme souhaitée d'une surface semi-conductrice de la tranche (1, 100) de semi-conducteur et un deuxième plateau (3) a une surface plane.

4. Procédé suivant l'une des revendications précédentes, dans lequel, pour obtenir l'effet de compression, on applique sur au moins l'un des deux plateaux (2, 3) une pression dans la direction perpendiculaire à la tranche (1, 100) de semi-conducteur.

5. Procédé suivant la revendication 4, dans lequel on applique sur les deux plateaux une pression dans la direction perpendiculaire à la tranche (1, 100) de semi-conducteur.

6. Procédé suivant la revendication 4 ou 5, dans lequel la pression est plus grande que 1 MPa et la température supérieure à 600°C.

7. Procédé suivant l'une ou plusieurs des revendications précédentes que l'on effectue dans une atmosphère de gaz inerte ou de gaz de protection, notamment sous azote ou sous argon.

8. Procédé suivant la revendication 1, dans lequel le semi-conducteur à composer est GaAs et on effectue le procédé dans une atmosphère enrichie en arsenic.

9. Procédé suivant l'une des revendications 1 ou 3 à 7, dans lequel la forme du au moins un plateau (2) comprend des structures (21) convexes et on produit des structures (11, 110) concaves, notamment des lentilles (10) microscopiques, par l'opération de compression dans la surface du semi-conducteur ;

10. Procédé suivant la revendication 2, dans lequel, avant la croissance de la succession (120, 130, 140) de couches actives, on fait croître une succession (120) de couches de réflecteur de Bragg sur une partie contenant la cavité (11, 110).

11. Procédé suivant la revendication 10, dans lequel, après la croissance de la succession (120, 130, 140) de couches actives, on fait croître une autre succession de couches de réflecteur de Bragg sur une partie contenant la cavité (11, 110) de manière à produire une diode laser verticale à résonateur.

12. Dispositif pour la mise en oeuvre du procédé suivant la revendication 1, comprenant
- deux plateaux (2, 3) dont l'un au moins a une forme négative par rapport à la forme souhaitée d'une surface de semi-conducteur de la tranche (1) de semi-conducteur ; et
- un dispositif de compression par lequel on peut appliquer sur au moins l'un des deux plateaux (2, 3) une pression dans la direction verticale à la tranche (1) de semi-conducteur,
**caractérisé en ce que**
- il est déposé sur la face, éloignée de la tranche (1) de semi-conducteur, des plateaux (2, 3) des structures (22, 32) bombées pour répartir la force de pression.

13. Dispositif suivant la revendication 12, dans lequel un premier plateau (2) a une forme négative par rapport à la forme souhaitée de la surface de semi-conducteur de la tranche (1) de semi-conducteur et un deuxième plateau (3) a une forme plane.

14. Dispositif suivant l'une des revendications 12 ou 13, dans lequel la tranche (1) de semi-conducteur à comprimer a, à la température de conformation, une dureté plus petite que le matériau du plateau (2) donnant la forme.

15. Dispositif suivant l'une des revendications 12 à 14, dans lequel les plateaux (2, 3) contiennent du silicium ou un métal, notamment du molybdène, et sont notamment en ces matériaux.
